# EUROPÄISCHE PATENTSCHRIFT

(11) **EP 1 909 548 B1**
(45) Veröffentlichungstag und Bekanntmachung des Hinweises auf die Patenterteilung: **07.10.2009**
(21) Anmeldenummer: 07009503.9
(22) Anmeldetag: 11.05.2007
(51) Int. Cl.: H05K 7/20

(54) **Filterlüfter**
Filter fan
Aérateur de filtre

(30) Priorität: 06.10.2006 DE 102006047316
(43) Veröffentlichungstag der Anmeldung: 09.04.2008
(73) Patentinhaber: Pfannenberg GmbH, 21035 Hamburg (DE)
(72) Erfinder: Pfannenberg, Andreas, 21035 Hamburg (DE); Reutter, Tobias, 48612 Horstmar (DE); Lodweg, Wolfgang, 48159 Münster (DE)
(74) Vertreter: Richter, Werdermann, Gerbaulet & Hofmann

(56) Entgegenhaltungen:
- DE-U1-202006 006 441
- DE-U1-202006 010 888
- US-A1- 2002 173 265

## Beschreibung

Die Erfindung betrifft einen Filterlüfter nach dem Oberbegriff des Anspruches 1.

Aus der Praxis sind gattungsgemäße Filterlüfter bekannt. Die Filtermedien, beispielsweise eine Vliesmatte, ist dabei in einem Rahmen gehalten, der nach außen hin durch ein Abdeckgitter und zum Gebläse hin durch ein Schutzgitter geschlossen ist, wobei die Vliesmatte zwischen diesen beiden Gittern gehalten ist und beiden Gittern anliegt. Die Filterlüfter werden beispielsweise in Schaltschränken und anderen Gehäusen eingesetzt, und zwar in einen Ausschnitt der jeweiligen Gehäusewand eingesetzt, um in dem Gehäuse angeordnete elektrische bzw. elektronische Komponenten zu kühlen Dabei ist vorgesehen, einen Staubeintrag in das Gehäuse so gering wie möglich zu halten, um nicht durch eine sich auf den Elektrokomponenten ablegende Staubschicht die Kühlleistung unbeabsichtigt zu reduzieren. Weiterhin weisen die Gebläse üblicherweise vergleichsweise geringe Leistungen auf, so dass der Druckabfall am Filtereinsatz möglichst gering zu halten ist, um nicht durch das Filtermedium selbst die Kühlleistung unzulässig zu reduzieren. Schließlich ist ein Feuchtigkeitsschutz gegen Spritzwasser vorgesehen, insbesondere bei Einrichtungen beispielsweise der Telekommunikation, die nicht in Firmenhallen aufgestellt sind, sondern beispielsweise im Freien aufgestellt sind.

In der Praxis sind Konstruktionen bewährt, die eine Schutzklasse von IP 54 aufweisen. Ein höherer-Feuchtigkeitsschutz kann beispielsweise durch Filtermembranen erzielt werden, wie sie aus der EP 1 098 692 B1 bekannt sind. Derartige Filtermembranen weisen jedoch den Nachteil auf, dass sie einen vergleichsweise hohen Druckabfall bewirken und insbesondere eine geringe Staubkapazität aufweisen. Zudem werden die dementsprechenden Filtermembranen auf ein Trägermaterial laminiert, was die Herstellung der Filter wirtschaftlich nachteilig beeinflusst. Insbesondere wenn bestimmte Eigenschaften vorgesehen sind, die entweder das Trägermaterial oder die Membran selbst nicht aufweisen, muss das jeweilige Material entsprechend ausgerüstet werden, wobei die Ausrüstung ggf. zweier Bestandteile des Laminats vor dem Laminiervorgang aufwendig ist und ggf. den Laminiervorgang erschweren und damit wiederum wirtschaftlich nachteilig beeinflussen kann.

Aus der DE 20 2006 006441 U1 ist ein Filterlüfter eines Schaltschrankes oder einer in einem Gehäuse angeordneten elektrischen und/oder elektronischen Einrichtung bekannt. Dieser ist mit einem einen Luftstrom erzeugenden Gebläse und mit einem Filterelement, welches im Luftstrom angeordnet ist und eine Reinseite, auf der das Gebläse angeordnet ist, von einer Rohseite trennt. Das Filterelement ist in einem Rahmen gehalten. Im Abstand zu dem Filter ist außenseitig eine Filterabdeckung angeordnet, in deren bodenseitigen Bereich die Lufteinlassöffnungen für die Frischluft ausgebildet sind. Die Filterabdeckung ermöglicht neben der Erzeugung eines Dichtungsdruckes einen Schutz gegen eine direkte Beaufschlagung des Filters mit Fluidteilchen der Frischluft. Der Rahmen 17 ist in einer Filterwanne. Dieser Filter 4 ist daher in einer Filterwanne aufgenommen, weiche als Vertiefung ausgebildet ist. Der Wannenboden ist mit Öffnungen versehen, durch welche die gefilterte Frischluft in den Innenraum des Gehäuses gelangt. Diese Lösung ist außerdem so, dass die Filterwanne im Prinzip komplementär zu dem Filter ausgebildet ist und eine Frischluftseite des Filters nahezu bündig mit der Filterwanne 6 abschließt, während an einer Luftaustrittsseite des Filters eine Dichtung umlaufend angeordnet ist, um den Filter gegen die Filterwanne abzudichten. Beschrieben wird, dass durch eine beabstandete Anordnung der Filterabdeckung ein Absaugkanal gebildet ist, in welchem Frischluft verteilt wird und über die gesamte Fläche des Filters in den Innenraum gelangt. Abstandshalter sind an der Innenseite der Filterabdeckung befestigt und reichen bis zu der Frischluftseite des Filters. Im bodenseitigen Bereich nahe der Lufteinlassöffnungen für die Frischluft sind Abscheidebleche für Fluidtröpfchen in der Frischluft angeordnet, und im bodenseitigen Filterrahmen sind Ablauflöcher für eingedrungenes Fluid ausgebildet.

Die US 2002/173265 A1 beschreibt eine Lüfteranordnung für ein Gehäuse mit einem Schutzgitter und einem Filter. Ein Aufnahmeteil weist unterschiedliche Tiefen auf, um verschiedene Filtertypen einsetzen zu können. Diese Filterkonstruktion dient zur Verbesserung der EMV bei Computern.

Der Erfindung liegt die Aufgabe zugrunde, einen gattungsgemäßen Filterlüfter dahingehend zu verbessern, dass dieser möglichst wirtschaftlich herstellbar ist, bei geringer erforderlicher Gebläseleistung und geringem Differenzdruck einen möglichst hohen Luftdurchsatz ermöglicht, und einen möglichst hohen Feuchtigkeitsschutz und eine hohe Staubkapazität gewährleistet.

Diese Aufgabe wird durch einen Filterlüfter mit den Merkmalen des Anspruches 1 gelöst.

Die Erfindung schlägt mit anderen Worten vor, das Filterelement vom Schutzgitter so weit zu beabstanden, dass Feuchtigkeit, welche in geringer Menge durch das Filterelement aufgrund dessen Porengröße gelangt ist, nun drucklos an der zum Gebläse gerichteten Reinseite des Filterelementes ablaufen kann, ohne in das Gebläse zu gelangen. Distanzstege o. dgl., durch welche die ablaufende Feuchtigkeit vom Filterelement zum Schutzgitter geleitet werden könnte, sind vermieden, so dass die Beabstandung überbrückungsfrei ausgeführt ist. Auf diese Weise kann ein vergleichsweise preisgünstiges Filterelement verwendet werden, welches eine hohe Luftdurchlässigkeit aufgrund seines großen Porenvolumens bietet. Wenn aufgrund des großen Porenvolumens unerwünschte Feuchtigkeit durch das Filterelement gelangen sollte, kann diese - wie vorbeschrieben - gefahrlos ablaufen, so dass der gewünschte Feuchtigkeitsschutz für das Gebläse und damit für den gesamten Filterlüfter ermöglicht wird.

Der überbrückungsfreie Abstand zwischen der Filterfläche und dem Schutzgitter ist insbesondere im Bereich des Luftdurchtritts vorgesehen, wo ansonsten der vom Gebläse angesaugte Luftstrom die Feuchtigkeit von der Filterfläche zu dem Schutzgitter transportieren bzw. einen solchen Transport begünstigen könnte.

Vorteilhaft kann das Filterelement eine mittlere Porengröße von wenigstens 20 µm aufweisen, insbesondere vorteilhaft zwischen 20 µm und 50 µm, so dass einerseits eine gute Filterleistung, insbesondere Staubabscheidung gewährleistet werden kann, andererseits jedoch ein möglichst geringer Druckabfall am Filterelement erfolgt, so dass ein hoher Luftdurchsatz durch den Filterlüfter und damit eine hervorragende Kühlleistung mittels des Filterlüfters ermöglicht wird.

In besonders einfacher und preisgünstiger Ausgestaltung des-Filterlüfters kann vorgesehen sein, dass der Abstand, den das Filterelement und insbesondere dessen Filterfläche zum Schutzgitter aufweist, durch einen Randbereich des Filterelementes bestimmt wird. Das Filterelement wird in an sich bekannter Weise in den Rahmen des Filterlüfters eingelegt. Der Rahmen weist üblicherweise Vorsprünge oder eine umlaufende Kante o. dgl. auf, die sich parallel zur Fläche des Filterelementes erstreckt und welcher Kante bzw. welchen Vorsprüngen das Filterelement in seinem umlaufenden Randbereich anliegt. Dadurch, dass am Rand des Filterelementes ein Vorsprung vorgesehen ist, kann ein Abstand zwischen Filterfläche und den Kanten bzw. Vorsprüngen des Rahmens erzielt werden, der dementsprechend auch einen Abstand zwischen dem Filterelement und insbesondre dessen Filterfläche einerseits und dem Schutzgitter andererseits bestimmt. In besonders einfacher und wirtschaftlich vorteilhafter Ausgestaltung kann dieser den Abstand bestimmende Randbereich des Filterelementes durch einen Materialstreifen gebildet sein, der an das Filterelement kaschiert ist. Üblicherweise werden derartige Materialstreifen ohnehin verwendet, um das Filterelement auszusteifen und vorschlagsgemäß ist es lediglich erforderlich, diesen ohnehin vorgesehenen Materialstreifen um wenige Millimeter Breite auszugestalten, so dass dieser Materialstreifen den abstandsbestimmenden Randbereich des Filterelementes bildet, welcher den Abstand der Filterfläche zum Schutzgitter des Filterlüfters bestimmt.

Vorteilhaft kann das Filterelement als Faltenfilter ausgestaltet sein. Auf diese Weise wird eine sehr große Filterfläche bei sehr kleinen baulichen Abmessungen des Filterelementes ermöglicht. Durch diese vergleichsweise große Filterfläche kann die mittlere Porengröße des Filterelementes vergleichsweise gering bemessen sein, um eine gute Filterleistung und damit ein hohes Rückhaltevermögen für die aus der Luft zu filternden Stäube zu gewährleisten, so dass eine bessere Filterleistung erzielbar ist als bei den aus der Praxis bekannten Filtervliesmatten.

Die Halterung des als Faltenfilter ausgestalteten Filterelementes im Rahmen kann auf einfache Weise mit so genannten Dichtungsstegen erfolgen, die an Rahmen vorgesehen sind und auf welche der Faltenfilter aufgesteckt wird, indem sich die Dichtungsstege in Falten des Filterelementes erstrecken. Um eine möglichst große nutzbare Filterfläche zu ermöglichen, sind dazu vorteilhaft die beiden äußersten Falten des Filterelementes vorgesehen, so dass die Dichtungsstege entsprechend möglichst weit voneinander beabstandet am Rahmen vorgesehen sind.

Wenn sich das Filterelement des Filterlüfters in seiner Gebrauchsstellung befindet und der Filterlüfter entsprechend in seiner Gebrauchsstellung am Gehäuse angeordnet ist, beispielsweise in einem Schalschrank, können die Falten des Filterelementes vorteilhaft vertikal verlaufen, so dass Feuchtigkeit, die durch das Filterelement gelangt und sich auf der Rückseite des Filterelementes zu Tröpfchen sammelt, besonders einfach und widerstandsarm am Filterelement ablaufen kann.

Wenn der Abstand des Filterelementes zum Schutzgitter durch einen Materialstreifen, wie vorerwähnt, bestimmt wird, so können bei Ausgestaltung des Filterelementes als Faltenfilter vorteilhaft zwei derartige Materialstreifen vorgesehen sein, die quer zur Faltenrichtung verlaufen und an den beiden einander gegenüberliegenden Rändern des Faltenfilters vorgesehen sind. Auf diese Weise wird eine Biegsamkeit des Filterelementes reduziert, die ansonsten durch die Vielzahl von Falten in einer Richtung gegeben wäre, so dass durch die Materialstreifen das Filterelement insgesamt leichter handhabbar, beispielsweise während seiner Montage im Filterlüfter wird.

Vorteilhaft kann das Filterelement aus einer einlagigen Materialbahn gebildet sein, beispielsweise aus einem Filterpapier oder aus einem Polyestervlies. Im Gegensatz zu mehrlagigen Materialien, beispielsweise Laminaten, ist die Herstellung des Filterelementes aus einer einlagigen Materialbahn deutlich wirtschaftlicher, so dass die Ausgestaltung des Filterlüfters möglichst preisgünstig erfolgen kann und insbesondere die Filterelemente, die regelmäßig gewartet und ausgewechselt werden müssen, können auf diese Weise möglichst wirtschaftlich hergestellt werden, so dass die Unterhaltskosten des Filterlüfters möglichst niedrig gehalten werden können.

Vorteilhaft kann das Filterelement hydrophob und/oder flammhemmend ausgestaltet sein. Durch die Hydrophobierung wird einerseits die Standfestigkeit des Filterelementes sichergestellt sowie ein Quellen des für das Filterelement verwendeten Werkstoffs verhindert, so dass Eigenschaften des Filterelementes wie Porengröße und Differenzdruck nicht durch Feuchtigkeitseinwirkung nachteilig beeinflusst werden. Die flammhemmende Ausgestaltung verbessert die Sicherheit des Filterlüfters.

Vorteilhaft kann der Rahmen an seiner Unterseite Wasseraustrittsöffnungen aufweisen, so dass an dem Filterelement herabgelaufenes Wasser aus dem Filterlüfter durch diese Wasseraustrittsöffnungen herausgeführt werden kann. Dabei sind die Wasseraustrittsöffnungen vorzugsweise so ausgestaltet, dass das Wasser zur Rohseite geführt wird, also nicht zum Gebläse oder zur Elektronik gelangen kann, die in dem Gehäuse angeordnet ist, in welchem sich der Filterlüfter befindet.

Vorteilhaft kann der Rahmen an seiner Unterseite Wasserablaufflächen aufweisen, die schräg nach unten zur Rohseite verlaufen und das Wasser aus dem-Innenraum des Gehäuses wegführen.

Vorteilhaft kann der Rahmen einen Klemmsitz des Filterelementes dadurch begünstigen, dass zum Filterelement gerichtete Vorsprünge am Rahmen vorgesehen sind. Insbesondere, wenn der Rahmen zu Wartungszwecken beweglich ist, beispielsweise klappbar oder schwenkbar am übrigen Filterlüfter vorgesehen ist, kann durch diesen Klemmsitz sichergestellt werden, dass einerseits das Filterelement in einer bequemen Handhabungsstellung ausgewechselt werden kann und der Rahmen anschließend aus seiner Filterwechselstellung bzw. Wartungsstellung in seine Gebrauchsstellung zurückbewegt wird und während dieser Bewegungen sichergestellt ist, dass das Filterelement an seinem vorgesehenen Ort innerhalb des Rahmens verbleibt, so dass anschließend, wenn sich der Rahmen in seiner Gebrauchsstellung befindet, die zuverlässige Funktion des Filterlüfters und insbesondere des Filterelementes sichergestellt ist.

Vorteilhaft ist in an sich bekannter Weise ein Abdeckgitter auf der Rohseite des Filterelementes angeordnet, welches einerseits einen mechanischen Schutz des Filterelementes und des Gebläses ermöglicht und welches andererseits so ausgestaltet ist, dass es das Eindringen von Feuchtigkeit, insbesondere von Spritzwasser, in den Filterlüfter erschwert. Hierzu kann in an sich bekannter Weise vorgesehen sein, das Abdeckgitter in Form mehrere Lamellen auszugestalten, die zwischen sich Luftdurchgangsöffnungen frei lassen. Die Lamellen sind dabei schräg gestellt angeordnet, um das Eindringen insbesondere von Wasser zu vermeiden, welches von schräg oben auf das Abdeckgitter trifft. Vorteilhaft kann dabei vorgesehen sein, die Lamellen jeweils auf ihrer Oberseite mit einer Feuchtigkeitsbarriere zu versehen, die in Form einer Rippe ausgestaltet ist, welche entlang der Lamelle auf deren Oberseite verläuft. Im Gegensatz zu einer steiler angestellten Ausrichtung der einzelnen Lamellen wird durch diesen zusätzlichen Strömungswiderstand für Feuchtigkeit, die ggf. an der Lamelle aufzusteigen bestrebt ist, ein zusätzlicher Strömungswiderstand geschaffen, so dass das Eindringen von Feuchtigkeit in den Filterlüfter, und zwar hinter das Abdeckgitter, erschwert wird.

Dabei kann besonders vorteilhaft vorgesehen sein, die Rippe auf der Oberseite der Lamelle widerhakenartig auszurichten, also im Querschnitt gesehen zur Rohseite hin verlaufen zu lassen, so dass die Wirkung der Feuchtigkeitssperre erhöht wird und ein regelrechter Wassersammelkanal gebildet wird.

Vorteilhaft kann an der Unterseite des Rahmens ein Wasserablaufkanal vorgesehen sein Dieser kann vorzugsweise als Siphon ausgestaltet sein. Hinter das Filterelement gelangtes Wasser, welches herabläuft und in diesen Wasserablaufkanal gelangt, wird somit zuverlässig vom Gebläse weggeführt. Bei der Ausgestaltung des Wasserablaufkanals als Siphon verschließt das Wasser automatisch den Wasserablaufkanal, so dass ein zuverlässiger Staubverschluss gegen von außen eindringenden Staub geschaffen ist. Die Ausgestaltung des Siphons erfolgt dabei vorzugsweise in Anpassung an die Gebläseleistung, so dass zuverlässig ausgeschlossen ist, dass durch einen vom Gebläse erzeugten Unterdruck Feuchtigkeit aus dem Wasserablaufkanal gesaugt wird.

Ein Ausführungsbeispiel der Erfindung wird anhand der rein schematischen Darstellungen nachfolgend näher erläutert. Dabei zeigt:
- Fig. 1: von der Reinseite aus gesehen einen Rahmen eines Filterlüfters,
- Fig. 2: in einer ähnlichen Ansicht wie Fig. 1 den Rahmen von Fig. 1 mit demontiertem Schutzgitter,
- Fig. 3: einen Ausschnitt durch den Rahmen von Fig. 1, als Vertikalschnitt,
- Fig. 4: eine Ansicht auf einen Ausschnitt des Rahmens von Fig. 2, in auseinander gezogener Darstellung und

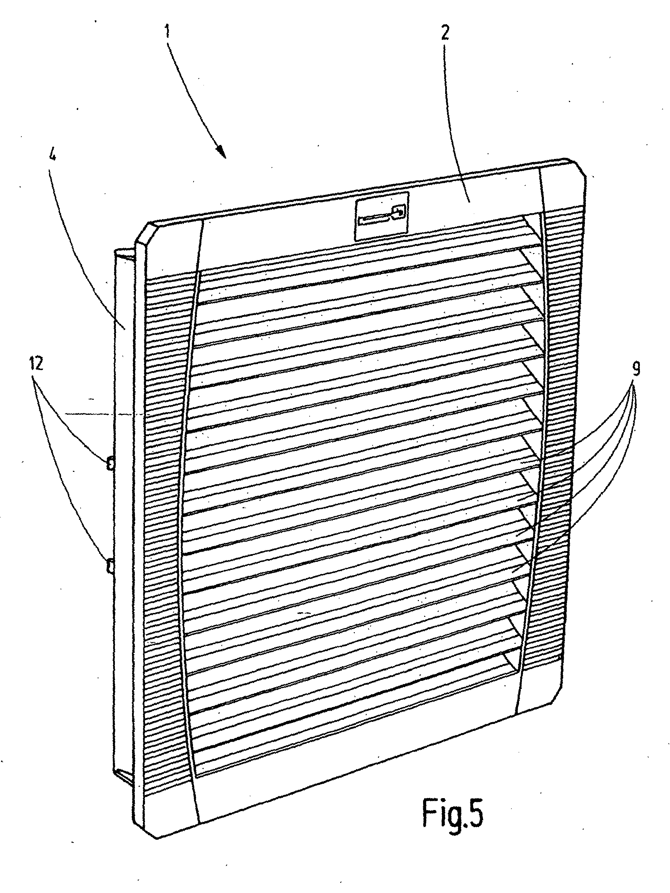

- Fig. 5: eine Ansicht von außen, also von der Rohseite, auf eine Schutzabdeckung eines Filterlüfters.

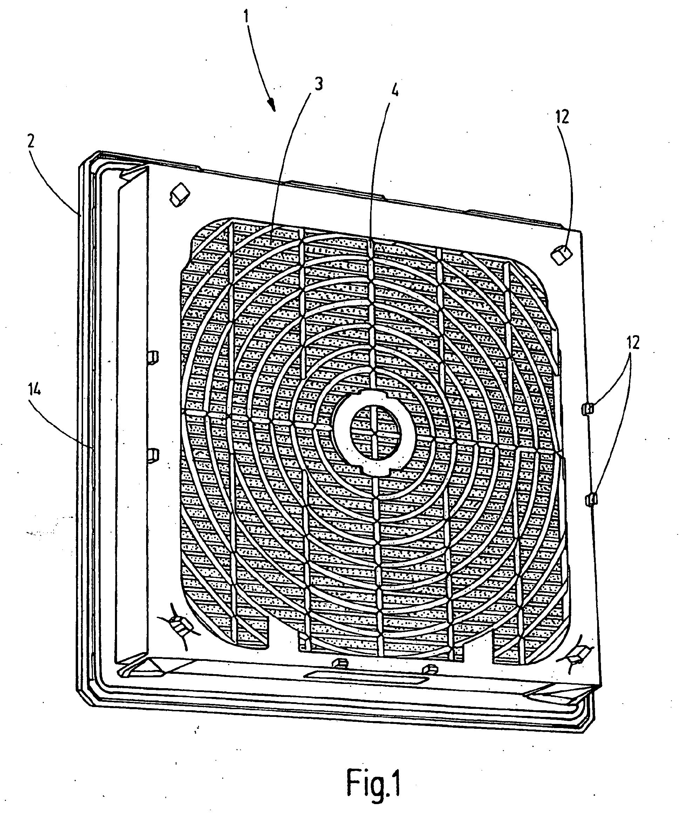

In Fig. 1 ist eine Schutzabdeckung eines Filterlüfters insgesamt mit 1 bezeichnet. Die Schutzabdeckung 1 weist ein äußeres, vom Betrachter der Fig. 1 abgewandtes Abdeckgitter 2 auf, von dem in Fig. 1 lediglich die Rückseite eines umlaufenden Rahmens ersichilch ist. Weiterhin weist die Schutzabdeckung 1 eine Filterelement 3 auf, welches als Faltenfilter ausgestaltet ist durch ein rückwärtiges Schutzgitter 4 abgedeckt ist, welches sich auf der Reinseite des Filterelementes 3 befindet. Hinter dem Schutzgitter in Strömungsrichtung der Luft gesehen, also auf der in Fig. 1 zum Betrachter hin gewandten Seite der Schutzabdeckung 1, ist das Gebläse des Filterlüfters vorgesehen.

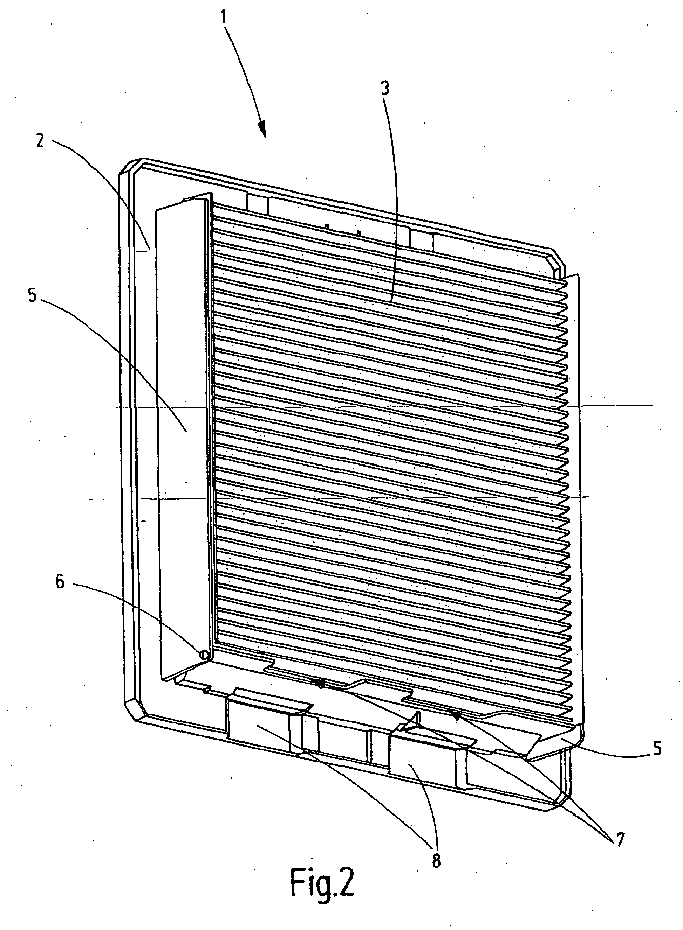

Fig. 2 zeigt die Schutzabdeckung 1 mit abgenommenem Schutzgitter. Die einzelnen Falten des Filterelementes 3 sind deutlich ersichtlich und es sind zwei Seitenwände 5 erkennbar, die auf der Rückseite des Abdeckgitters 2 angeformt sind und zwischen denen sich das Filterelement 3 befindet. Zum Filterelement 3 hin verlaufen auf den Seitenwäden 5 Stege, die einen Klemmsitz des Filterelementes 3 bewirken, so dass das Abdeckgitter 2 gemeinsam mit dem Filterelement 3 gehandhabt werden kann. An den Außenflächen der Seitenwände 5 ist jeweils unten ein Führungszapfen 6 vorgesehen, wobei der Führungszapfen 6 zur Reinseite hin, also zum Schutzgitter 4 hin, abgeschrägt ist, so dass eine Bewegung vereinfacht wird, bei welcher das Abdeckgitter 2 auf das Schutzgitter 4 aufgeschoben bzw. in das Schutzgitter 4 eingeschoben wird. Entsprechende Führungsnuten innerhalb des Schutzgitters 4 führen dabei die beiden Führungszapfen 6. Die Führungszapfen 6 dienen bei montiertem Filterlüfter als Scharnierstifte, so dass bei ortsfest verbleibendem Filterlüfter das vordere Abdeckgitter 2 um die Scharnierstifte in Form der Führungszapfen 6 verschwenkt werden und nach außen aufgeklappt werden kann, so dass von außerhalb des Gehäuses, in welches der Filterlüfter eingesetzt ist, ein Zugang zum Filterelement 3 geschaffen wird, so dass mit möglichst wenig Aufwand ein schneller und unkomplizierter Wechsel des Filterelementes 3 ermöglicht wird.

Im unteren Bereich des Abdeckgitters ist an dessen Rückseite, unterhalb des Filterelementes 3, die Anordnung von zwei Wasserablauföffnungen 7 vorgesehen, wobei das Wasser zu Wasserablaufschlitzen 8 gelangt, die im unteren Bereich des Abdeckgitters 2 vorgesehen sind, so dass das Wasser, welches hinter das Filterelement 3 gelangt ist, also auf die Reinseite des Filterelementes 3, nach untern fließen und durch die Wasserablauföffnungen 7 und die Wasserablaufschlize 8 auf Außenseite des Gehäuses geführt wird, in welches der Filterlüfter eingesetzt ist.

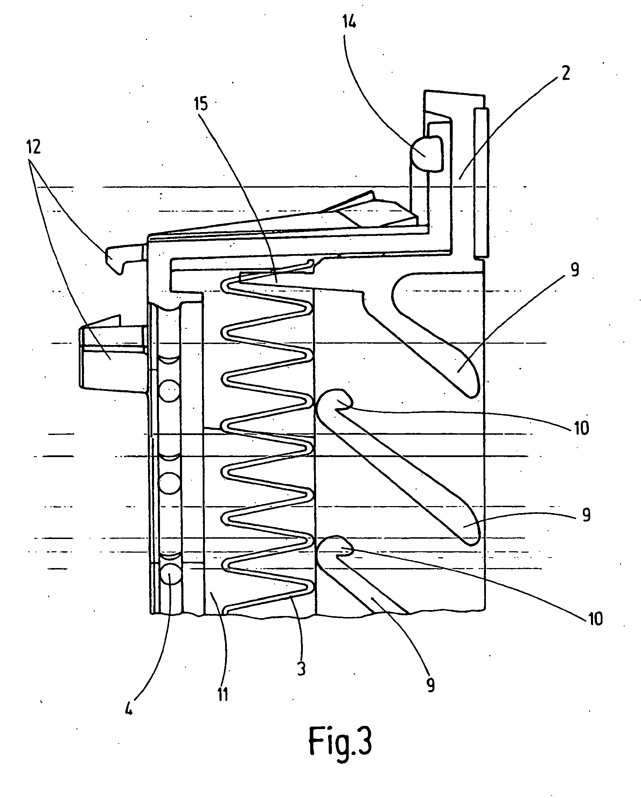

Fig. 3 zeigt einen Vertikalschnitt durch den oberen Bereich der Schutzabdeckung 1: Das Abdeckgitter 2 ist mit mehreren Lamellen 9 versehen. Die Lamellen 9 sind schräg gestellt und steigen zum Filterelement 3 an, so dass auf die Lamellen 9 gelangendes Spritzwasser oder Niederschlagswasser grundsätzlich von dem Filterelement 3 weggeführt wird zur Vorderseite bzw. Außenseite bzw. Rohseite des Filterlüfters.

Bis auf die oberste Lamelle sind die anderen Lamellen 9 sämtlich mit einer Rippe 10 versehen, die auf der Oberseite und zwar am oberen Ende jeder Lamelle 9 vorgesehen ist und widerhakenartig im Querschnitt ausgeformt ist, so dass zusätzlich zur Schrägstellung der Lamelle 9 ein zusätzliche Widerstand für aufsteigendes Wasser geschaffen wird.

Das Filterelement 3 weist an seinen beiden Seiten aufkaschierte Materialstreifen 11 auf, welche das Filterelement 3 aussteifen. Die Materialstreifen 11 sind so breit bemessen, dass sie sich über die Reinseite des Filterelementes 3 hinaus weiter erstrecken. Diese Materialstreifen bewirken einen Abstand der Filterfläche des Filterelementes 3 zum Schutzgitter 4, so dass Wasser, welches die Lamellen 9 und Rippen 10 überwunden hat, an das Filterelement 3 gelangt ist und durch das Filterelement hindurchgetreten ist, nun drucklos auf der Rückseite des Filterelementes 3 ablaufen kann. Feuchtigkeit, die als dünner Feuchtigkeitsfilm am Filterelement 3 herabrinnt, findet ohne keinen Kontakt zum Schutzgitter 4. Aber auch größere Wassertropfen, die sich ggf. an der Rückseite des Filterelementes 3 bilden, gelangen aufgrund des Abstandes zwischen der Filterfläche es Filterelementes 3 und dem Schutzgitter nicht in Kontakt mit dem Schutzgitter, so dass sie nicht die gesamte Schutzabdeckung 1 durchdringen können und auf die reinseitige Oberfläche des Schutzgitters 4 oder zu dem Gebläse gelangen können Das Schutzgitter 4 weist mehrere Clipselemente 12 auf, durch die es mit dem Gebläse werkzeuglos verbunden werden kann und/oder mit dem Gehäuse des Schaltschrankes, so dass mithilfe dieser Clipselemente 12 der gesamte Filterlüfter werkzeuglos in dem Gehäuse montiert werden kann. Die Einbauöffnung des Gehäuses wird durch eine aus den Fig. 1 und 3 ersichtliche Dichtung abgedichtet, so dass der Luftzutritt in das Innere des Gehäuses im Wesentlichen ausschließlich über das Filterelement 3 erfolgt.

Aus Fig. 3 ist weiterhin ersichtlich, dass am Abdeckgitter 2 Dichtungsstege 15 vorgesehen sind, wobei der obere Dichtungssteg 15 dargestellt ist. Der Dichtungssteg 15 dient zur Aufnahme des Filterelementes 3 und verläuft in der Richtung, in welcher auch die Falten des Filterelementes 3 verlaufen, so dass auf einfache, werkzeuglose Weise das Dichtungselement auf die Dichtungsstege 15 aufgesteckt werden kann.

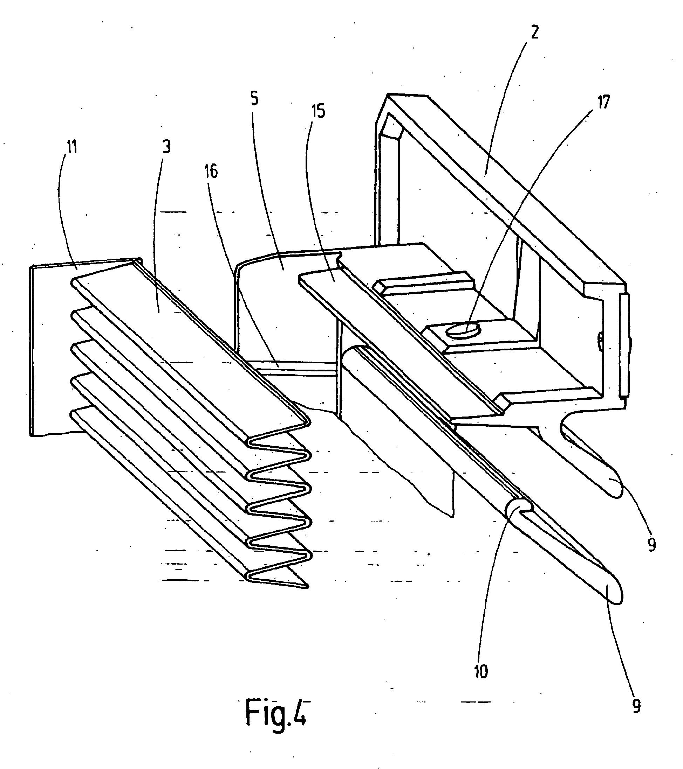

Aus Fig. 4 ist der Aufbau des Filterelementes 3 mit seinen beiden seitlichen Materialstreifen 11 ersichtlich, wobei das Filterelement 3 im Schnitt dargestellt ist, so dass nur einer dieser Materialstreifen 11 dargestellt ist. Der zur Reinseite hin weisende Überstand des Materialstreifens 11, der den Abstand der Filterfläche vom Schutzgitter 4 bestimmt, ist aus Fig. 4 deutlich erkennbar.

Weiterhin zeigt Fig. 4 auf der Seitenwand 5 einen mit 16 gekennzeichneten Steg, der den Klemmsitz des Filterelementes 3 zwischen den beiden Seitenwänden 5 bewirkt, und Fig. 4 zeigt ein weiteres Clipselement 17, welches zur Verrastung des Abdeckgitters 2 mit dem Schutzgitter 4 dient und dementsprechend angeschrägt ausgestaltet ist, um ein leichtes Aufrasten des Schutzgitters 4 auf dem Abdeckgitter 2 zu ermöglichen. Das Abdeckgitter 2 und das Schutzgitter 4 bilden gemeinsam einen das Filterelement 3 umgebenden Rahmen.

## Patentansprüche

1. Filterlüfter eines Schaltschrankes oder einer in einem Gehäuse angeordneten elektrischen und/oder elektronischen Einrichtung, mit einem einen Luftstrom erzeugenden Gebläse,
und mit einem Filterelement (3), welches im Luftstrom angeordnet ist und eine Reinseite, auf der das Gebläse angeordnet ist, von einer Rohseite trennt,
wobei das Filterelement (3) in einem Rahmen gehalten ist, welcher an dem Gehäuse, eine die Gehäusewand durchsetzende Luftdurchlassöffnung abdeckend, befestigbar ist, und wobei ein Schutzgitter (4) zwischen dem Filterelement (3) und dem Gebläse angeordnet ist,
**dadurch gekennzeichnet,**
**dass** zwischen der Filterfläche des Filterelementes (3) und dem Schutzgitter (4) ein überbrückungsfreier Abstand vorgesehen ist,
wobei dieser Abstand des Ablaufen von Wassertropfen an der reinseitigen Oberfläche des Filterelementes (3) ermöglichend und einen Kontakt der Wassertropfen mit dem Schutzgitter (4) vermeidend bemessen ist.

2. Filterlüfter nach Anspruch 1,
**dadurch gekennzeichnet,**
**dass** das Filterelement (3) eine mittlere Porengröße von wenigstens 20 µm aufweist.

3. Filterlüfter nach einem der Ansprüche 1 oder 2,
**dadurch gekennzeichnet,**
**dass** das Filterelement (3) eine mittlere Porengröße zwischen 20 µm und 50 µm aufweist.

4. Filterlüfter nach einem der Ansprüche 1 bis 3,
**dadurch gekennzeichnet,**
**dass** der Abstand zum Schutzgitter (4) durch einen Randbereich des Filterelementes (3) bestimmt wird, mit welchem das Filterelement (3) an dem Rahmen anliegt.

5. Filterlüfter nach Anspruch 4,
**dadurch gekennzeichnet,**
**dass** dieser Randbereich des Filterelementes (3) durch einen an das übrige Filterelement (3) kaschierten Materialstreifen (11) gebildet ist.

6. Filterlüfter nach einem der Ansprüche 1 bis 5,
**dadurch gekennzeichnet,**
**dass** das Filterelement (3) als Faltenfilter ausgestaltet ist.

7. Filterlüfter nach den Ansprüchen 5 und 6,
**dadurch gekennzeichnet,**
**dass** an zwei gegenüberliegenden Rändern des Filterelementes (3) jeweils ein Materialstreifen (11) vorgesehen ist, wobei die Materialstreifen (11) quer zu den Falten des Filterelementes (3) verlaufen.

8. Filterlüfter nach Anspruch 6,
**dadurch gekennzeichnet,**
**dass** an dem Rahmen Dichtungsstege (15) vorgesehen sind, welche sich in Falten des Filterelementes (3) erstrecken.

9. Filterlüfter nach Anspruch 8,
**dadurch gekennzeichnet,**
**dass** sich die Dichtungsstege (15) in die beiden äußersten Falten des Filterelementes (3) erstrecken.

10. Filterlüfter nach Anspruch 6,
**dadurch gekennzeichnet,**
**dass** die Falten des Filterelementes (3) in vertikaler Richtung verlaufend ausgerichtet sind.

11. Filterlüfter nach einem der Ansprüche 1 bis 10,
**dadurch gekennzeichnet,**
**dass** das Filterelement (3) aus einer einlagigen Materialbahn gebildet ist.

12. Filterlüfter nach Anspruch 11,
**dadurch gekennzeichnet,**
**dass** das Filterelement (3) aus einem Polyestervlies gebildet ist.

13. Filterlüfter nach einem der Ansprüche 1 bis 12,
**dadurch gekennzeichnet,**
**dass** der Rahmen an seiner Unterseite Wasseraustrittsöffnungen aufweist.

14. Filterlüfter nach einem der Ansprüche 1 bis 13,
**dadurch gekennzeichnet,**
**dass** der Rahmen an seiner Unterseite schräg nach unten zur Rohseite verlaufende Wasserablaufffächen aufweist.

15. Filterlüfter nach einem der Ansprüche 1 bis 14,
**dadurch gekennzeichnet,**
**dass** der Rahmen zu dem Filterelement (3) gerichtete Stege (16) aufweist, welche das Filterelement (3) am Rahmen klemmend halten.

16. Filterlüfter nach einem der Ansprüche 1 bis 15,
**dadurch gekennzeichnet,**
**dass** ein Abdeckgitter (2) auf der Rohseite des Filterelementes (3) angeordnet ist, das mehrere durch Lamellen (9) voneinander getrennte Luftdurchgangsöffnungen aufweist, wobei die Lamellen (9) jeweils von der Rohseite zur Reinseite ansteigend verlaufen, und an ihrer Oberseite eine Feuchtigkeitsbarriere in Form einer entlang der Lamelle (9) verlaufenden Rippe (10) aufweisen.

17. Filterlüfter nach Anspruch 16,
**dadurch gekennzeichnet,**
**dass** die Rippe (10) auf der Oberseite der Lamelle (9) widerhakenartig zur Rohseite weisend ausgerichtete ist.

18. Filterlüfter nach einem der Ansprüche 1 bis 17,
**dadurch gekennzeichnet,**
**dass** an der Unterseite des Reahmens ein als Siphon ausgestalteter Wasserablaufkanal vorgesehen ist.

19. Filterelement (3) eines Filterlüfters nach einem der Ansprüche 1 bis 18.

## Claims

1. A filter fan for an electrical cabinet or an electrical and/or electronic device arranged in a housing, with a blower generating an air flow, and with a filter element (3), which is arranged in the air flow and a clean face, on which the blower is arranged, separated from an untreated face, wherein
the filter element (3) is held in a frame, which can be attached to the housing, covering an air passage opening that penetrates the housing wall, and wherein
a protective grid (4) is arranged between the filter element (3) and the blower,
**characterised in that** a spacing is provided without any bridges between the filter surface of the filter element (3) and the protective grid (4), wherein
this spacing is dimensioned to enable the drainage of water droplets on the clean face of the filter element (3), and to prevent any contact between the water droplets and the protective grid (4).

2. The filter fan according to Claim 1,
**characterised in that** the filter element (3) has an average pore size of at least 20 µm.

3. The filter fan according to one of the Claims 1 or 2,
**characterised in that** the filter element (3) has an average pore size of between 20 µm and 50 µm.

4. The filter fan according to one of the Claims 1 to 3,
**characterised in that** the spacing from the protective grid (4) is determined by an edge region of the filter element (3), with which the filter element (3) abuts against the frame.

5. The filter fan according to Claim 4,
**characterised in that** this edge region of the filter element (3) is formed by a material strip (11) laminated to the residual filter element (3).

6. The filter fan according to one of the Claims 1 to 5,
**characterised in that** the filter element (3) is configured as a folded filter.

7. The filter fan according to the Claims 5 and 6,
**characterised in that** a material strip (11) is provided on each of the two opposing edges of the filter element (3), wherein
the material strips (11) run cross-wise to the folds of the filter element (3).

8. The filter fan according to Claim 6,
**characterised in that** on the frame sealing lands (15) are provided, which extend into folds of the filter element (3).

9. The filter fan according to Claim 8,
**characterised in that** the sealing lands (15) extend into the two outermost folds of the filter element (3).

10. The filter fan according to Claim 6,
**characterised in that** the folds of the filter element (3) are aligned running in a vertical direction.

11. The filter fan according to one of the Claims 1 to 10,
**characterised in that** the filter element (3) is formed from a single layer web of material.

12. The filter fan according to Claim 11,
**characterised in that** the filter element (3) is formed from a polyester fleece.

13. The filter fan according to one of the Claims 1 to 12,
**characterised in that** the frame has water outlet openings on its lower face.

14. The filter fan according to one of the Claims 1 to 13,
**characterised in that** the frame has water drainage surfaces on its lower face running obliquely downwards to the untreated face.

15. The filter fan according to one of the Claims 1 to 14,
**characterised in that** the frame has lands (16) directed towards the filter element (3), which clamp the filter element (3) to the frame.

16. The filter fan according to one of the Claims 1 to 15,
**characterised in that** a cover grid (2) is arranged on the untreated face of the filter element (3), which grid has a plurality of air passage openings separated from one another by fins (9), wherein
each of the fins (9) runs upward from the untreated face to the clean face, and on its upper face has a moisture barrier in the form of a rib (10) running along the fin (9).

17. The filter fan according to Claim 16,
**characterised in that** the rib (10) on the upper face of the fin (9) is aligned pointing towards the untreated face in the manner of a barbed hook.

18. The filter fan according to one of the Claims 1 to 17,
**characterised in that** a water drainage passage configured as a siphon is provided on the lower face of the frame.

19. A filter element (3) of a filter fan according to one of the Claims 1 to 18.

## Revendications

1. Aérateur de filtre d'une armoire de commutation ou d'un dispositif électrique et/ou électronique placé dans un boîtier, comprenant une soufflante produisant un flux d'air et un élément filtrant (3) qui est placé dans le flux d'air et un côté de fluide purifié sur lequel la soufflante est placée, séparé d'un côté de fluide non purifié, l'élément filtrant (3) étant maintenu dans un cadre qui peut être fixé sur le boîtier en couvrant une ouverture de passage d'air traversant la paroi du boîtier et une grille de protection (4) étant placée entre l'élément filtrant (3) et la soufflante, **caractérisé en ce qu'**entre la surface filtrante de l'élément filtrant (3) et la grille de protection (4) , un écartement sans enjambement est prévu, cet écartement étant mesuré pour permettre l'écoulement de gouttes d'eau sur la surface du côté de fluide purifié de l'élément filtrant (3) et éviter un contact des gouttes d'eau avec la grille de protection (4).

2. Aérateur de filtre selon la revendication 1, **caractérisé en ce que** l'élément filtrant (3) présente une taille de pores moyenne d'au moins 20 µm.

3. Aérateur de filtre selon la revendication 1 ou 2, **caractérisé en ce que** l'élément filtrant (3) présente une taille de pores moyenne entre 20 µm et 50 µm.

4. Aérateur de filtre selon l'une des revendications 1 à 3, **caractérisé en ce que** l'écartement jusqu'à la grille de protection (4) est défini par une zone de bordure de l'élément filtrant (3) avec laquelle l'élément filtrant (3) repose sur le cadre.

5. Aérateur de filtre selon la revendication 4, **caractérisé en ce que** cette zone de bordure de l'élément filtrant (3) est formée par une bande de matériau (11) collée sur l'élément filtrant (3) restant.

6. Aérateur de filtre selon l'une des revendications 1 à 5, **caractérisé en ce que** l'élément filtrant (3) est formé comme un filtre à plis.

7. Aérateur de filtre selon les revendications 5 et 6, **caractérisé en ce que** sur deux bords opposés de l'élément filtrant (3), une bande de matériau (11) respective est prévue, les bandes de matériau (11) étant transversales aux plis de l'élément filtrant (3).

8. Aérateur de filtre selon la revendication 6, **caractérisé en ce que** des lames d'étanchéité (15) sont prévues sur le cadre, lesquelles s'étendent dans les plis de l'élément filtrant (3).

9. Aérateur de filtre selon la revendication 8, **caractérisé en ce que** les lames d'étanchéité (15) s'étendent dans les deux plis les plus à l'extérieur de l'élément filtrant (3).

10. Aérateur de filtre selon la revendication 6, **caractérisé en ce que** les plis de l'élément filtrant (3) sont dirigés dans le sens vertical.

11. Aérateur de filtre selon l'une des revendications 1 à 10, **caractérisé en ce que** l'élément filtrant (3) est formé dans une bande de matériau monocouche.

12. Aérateur de filtre selon la revendication 11, **caractérisé en ce que** l'élément filtrant (3) est fabriqué dans du non-tissé de polyester.

13. Aérateur de filtre selon l'une des revendications 1 à 12, **caractérisé en ce que** le cadre présente des ouvertures de passage d'eau sur sa face inférieure.

14. Aérateur de filtre selon l'une des revendications 1 à 13, **caractérisé en ce que** le cadre présente sur sa face inférieure des surfaces d'écoulement de l'eau inclinées vers le bas par rapport au côté de fluide non purifié.

15. Aérateur de filtre selon l'une des revendications 1 à 14, **caractérisé en ce que** le cadre présente des lames (16) dirigées vers l'élément filtrant (3) qui maintiennent l'élément filtrant (3) bloqué sur le cadre.

16. Aérateur de filtre selon l'une des revendications 1 à 15, **caractérisé en ce qu'**une grille de recouvrement (2) est placée sur le côté de fluide non purifié de l'élément filtrant (3), laquelle présente plusieurs ouvertures de passage de l'air séparées les unes des autres par des lamelles (9), les lamelles (9) montant respectivement du côté de fluide non purifié vers le côté de fluide purifié, et présentent sur leur face supérieure une barrière contre l'humidité sous forme d'une nervure (10) s'étendant le long de la lamelle (9).

17. Aérateur de filtre selon la revendication 16, **caractérisé en ce que** la nervure (10) est placée sur la face supérieure de la lamelle (9) en étant dirigée comme un barbillon par rapport au côté de fluide non purifié.

18. Aérateur de filtre selon l'une des revendications 1 à 17, **caractérisé en ce que** sur la face inférieure du cadre, un canal d'écoulement de l'eau formé comme un siphon est prévu.

19. Elément filtrant (3) d'un aérateur de filtre selon l'une des revendications 1 à 18.
